# EUROPEAN PATENT APPLICATION

(11) **EP 2 779 252 A2**
(43) Date of publication of application: **17.09.2014**
(21) Application number: 14159754.2
(22) Date of filing: 14.03.2014
(51) Int. Cl.: H01L 31/0224, H01L 31/05

(54) **Photovoltaic cell, photovoltaic cell module and method of fabricating the same**

(30) Priority: 14.03.2013 TW 102109075
(71) Applicant: Ever Energy PV Corp., Jhongli City 32068 (TW)
(72) Inventor: Tseng, Yu-Chu, Jhongli City (TW); Wang, John-Sun, Jhongli City (TW)
(74) Representative: Becker Kurig Straus

(57) **Abstract**

A photovoltaic cell module configured to convert energy of light into electric energy is provided. The photovoltaic cell module includes photovoltaic cells (100) and at least one bus element (200). A first electrode (130) of one of the photovoltaic cells is electrically connected to another of the photovoltaic cells through the bus element. Each photovoltaic cell includes a first-type semiconductor layer (110), a second-type semiconductor layer (120), and a first electrode (130). The second-type semiconductor layer has an interface (S) in contact with the first-type semiconductor layer. The first-type semiconductor layer is located between the first electrode and the second-type semiconductor layer. The light enters each photovoltaic cell along a direction from the first electrode to the interface. The first electrode includes first (132) and second electricity-collecting portions (134) which cross with each other and belong to a single film layer. A method of fabricating a photovoltaic cell module and a photovoltaic cell are also provided.

## Description

### Field of the Invention

The invention relates to a photoelectric device, a photoelectric device module, and a method of fabricating the same; more particularly, the invention relates to a photovoltaic cell, a photovoltaic cell module, and a method of fabricating the same.

### Description of Related Art

Along with the development of technology and economy, the use of energy (such as petroleum, natural gas, coal, and so forth) has caused pollution which leads to serious damages to the environment. Further, the supply of these polluting energies is coming to a close, and the shortage of energy has become a serious world-wide problem. Accordingly, development of pollution-free and renewable energy sources has attracted more and more attention.

One way to acquire the renewable energy sources is to convert optical energy into electric energy by means of a photovoltaic cell module. The photovoltaic cell module includes a plurality of photovoltaic cells and a plurality of bus elements. In the process of manufacturing the photovoltaic cell module, the photovoltaic cells are required to be connected, so as to collect the electric energy generated by these photovoltaic cells through conversion. However, according to the related art, it is necessary to connect the photovoltaic cells to at least one of the bus elements in a one-by-one manner; hence, the conventional process of manufacturing the photovoltaic cell module consumes significant time and labor costs. Moreover, according to the related art, a great portion of the light-receiving surfaces of the photovoltaic cells may be covered by the bus elements, which results in unfavorable photoelectric conversion efficiency of the conventional photovoltaic cell module.

### SUMMARY OF THE INVENTION

The invention is directed to a photovoltaic cell module that can be formed by performing a simple manufacturing process and can efficiently convert optical energy into electric energy.

The invention is also directed to a method of fabricating a photovoltaic cell module, and the method can be applied to reduce manufacturing costs of the photovoltaic cell module.

In an embodiment of the invention, a photovoltaic cell that includes a first-type semiconductor layer, a second-type semiconductor layer, and a first electrode is provided. The second-type semiconductor layer has an interface in contact with the first-type semiconductor layer. The first-type semiconductor layer is located between the first electrode and the second-type semiconductor layer. Light enters each of the photovoltaic cell along a direction from the first electrode to the interface. The first electrode includes a plurality of first electricity-collecting portions and a plurality of second electricity-collecting portions. The first electricity-collecting portions and the second electricity-collecting portions cross with each other and belong to the same film layer.

In an embodiment of the invention, a photovoltaic cell module configured to convert energy of light into electric energy is provided. The photovoltaic cell module includes a plurality of said photovoltaic cells and at least one bus element. The first electrode of one of the photovoltaic cells is electrically connected to another of the photovoltaic cells through the bus element.

In an embodiment of the invention, a method of fabricating a photovoltaic cell module includes following steps. A plurality of photovoltaic cells as mentioned above are provided. At least one bus element is provided. The photovoltaic cells are simultaneously fixed to and electrically connected to the at least one bus element.

In view of the above, in the photovoltaic cell and the photovoltaic cell module according to an embodiment of the invention, the area of the bus element is reduced by the special design of the electrode so that the area of the light-receiving surface covered by the bus element can be reduced. Thereby, the photoelectric conversion efficiency can be enhanced. In addition, according to the method of fabricating the photovoltaic cell module provided herein, the specially designed electrodes and the bus element contribute to the simplification of the manufacturing process of the photovoltaic cell module, and the manufacturing costs of the photovoltaic cell module are further reduced.

In order to make the aforementioned and other features and advantages of the invention comprehensible, embodiments accompanied with figures are described in detail below.

### BRIEF DESCRIPTION OF THE DRAWINGS

FIG. 1 is a flowchart illustrating a method of fabricating a photovoltaic cell module according to an embodiment of the invention.
FIG. 2A to FIG. 2D are schematic top views illustrating a process of fabricating a photovoltaic cell module according to an embodiment of the invention.
FIG. 3 is a schematic cross-sectional view taken along a section line A-A' depicted in FIG. 2A.
FIG. 4 is a cross-sectional view taken along a section line B-B' shown in FIG. 2D.
FIG. 5 is a schematic top view illustrating a photovoltaic cell module according to an embodiment of the invention.
FIG. 6A to FIG. 6D are schematic top views illustrating a method of fabricating a photovoltaic cell module according to an embodiment of the invention.
FIG. 7 is a schematic top view illustrating a photovoltaic cell module according to an embodiment of the invention.

### DETAILED DESCRIPTION OF DISCLOSED EMBODIMENTS

### First Embodiment

### Method of Fabricating Photovoltaic Cell Module

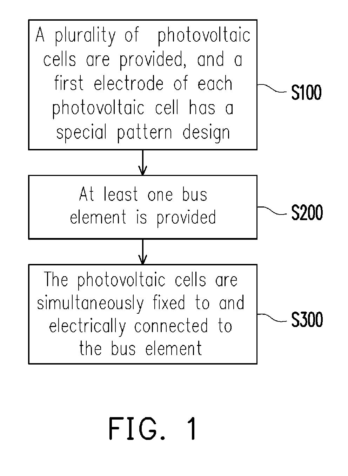

FIG. 1 is a flowchart illustrating a method of fabricating a photovoltaic cell module according to an embodiment of the invention. The method includes steps as follows. A plurality of photovoltaic cells are provided, and a first electrode of each photovoltaic cell has a special pattern design (step 100). At least one bus element is provided (step 200). The photovoltaic cells are simultaneously fixed to and electrically connected to the bus element (step 300). The order of performing the steps 100, 200, and 300 may be appropriately modified. Through the special pattern design of the first electrodes of the photovoltaic cells, two adjacent photovoltaic cells are allowed to be simultaneously fixed to and electrically connected to the bus element. Thereby, the manufacturing process of the photovoltaic cell module can be simplified, and the manufacturing costs may be lowered down. Moreover, the light-receiving area of the photovoltaic cell can be expanded because of the special pattern design, and thus the photoelectric conversion efficiency of the photovoltaic cell module can be enhanced.

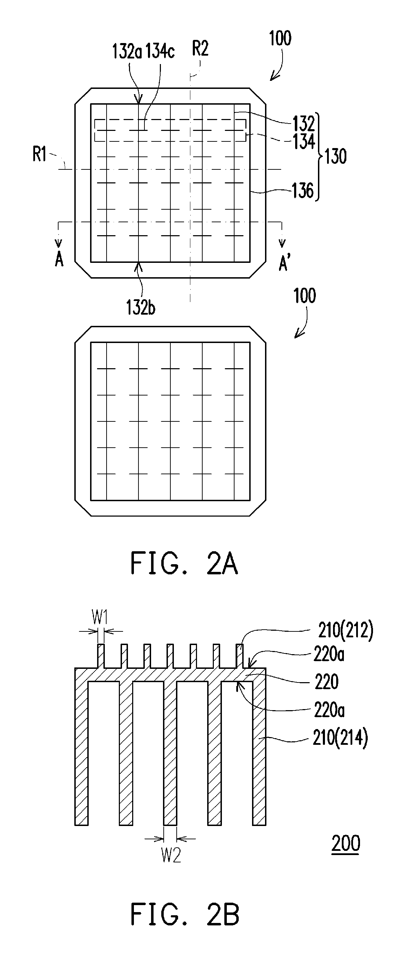

How the special pattern design of the first electrodes of the photovoltaic cells contributes to the reduction of the manufacturing costs of the photovoltaic cells and the improvement of the photoelectric conversion efficiency of the photovoltaic cells will be described in the following embodiments with reference to FIG. 2A to FIG. 2D, FIG. 3, and FIG. 4.

FIG. 2A to FIG. 2D are schematic top views illustrating a process of fabricating a photovoltaic cell module according to an embodiment of the invention. With reference to FIG. 2A, a plurality of photovoltaic cells 100 are provided. In FIG. 2A, two photovoltaic cells 100 are exemplified, whereas the number of the photovoltaic cells 100 is not limited in the invention; as long as there are two or more photovoltaic cells 100, the number of the photovoltaic cells 100 does not depart from the scope of the invention.

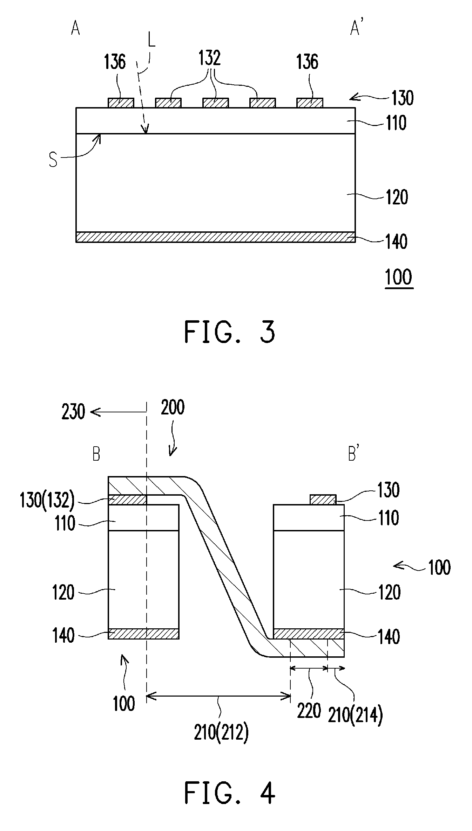

FIG. 3 is a schematic cross-sectional view taken along a section line A-A' depicted in FIG. 2A. With reference to FIG. 2A and FIG. 3, the photovoltaic cells 100 provided in the present embodiment serve to convert energy of light L into electric energy. Each of the photovoltaic cells 100 includes a first-type semiconductor layer 110, a second-type semiconductor layer 120, and a first electrode 130. The first-type semiconductor layer 110 is located between the first electrode 130 and the second-type semiconductor layer 120. An interface S is between the first-type semiconductor layer 110 and the second-type semiconductor layer 120. The light L enters each of the photovoltaic cells 110 along a direction from the first electrode 130 to the interface S. That is, the surface where the first electrode 130 is located is the light-receiving surface of each photovoltaic cells 100.

In the present embodiment, the first-type semiconductor layer 110 is a p-type semiconductor layer, for instance, and the second-type semiconductor layer 120 is an n-type semiconductor layer, for instance. However, the invention is not limited thereto; in another embodiment of the invention, the first-type semiconductor layer 110 may be an n-type semiconductor layer, and the second-type semiconductor layer 120 may be a p-type semiconductor layer, for instance. Each of the photovoltaic cells 100 described in the present embodiment further includes a second electrode 140. The second-type semiconductor layer 120 is located between the first-type semiconductor layer 110 and the second electrode 140. The first electrodes 130 and the second electrodes 140 are made of conductive materials, such as metal (e.g., silver, aluminum, and so on), alloy (e.g., silver-aluminum alloy), etc..

With reference to FIG. 2A, the first electrode 130 described in the present embodiment includes a plurality of first electricity-collecting portions 132 and a plurality of second electricity-collecting portions 134. The first electricity-collecting portions 132 and the second electricity-collecting portions 134 cross with each other. In the present embodiment, the first electricity-collecting portions 132 are parallel to each other, and the second electricity-collecting portions 134 are parallel to each other. In the present embodiment, an included angle between an extension direction of the first electricity-collecting portions 132 and an extension direction of the second electricity-collecting portions 134 is 90 degrees, for instance. However, as long as said included angle is not zero degree, the included angle falls within the scope of the invention.

According to the present embodiment, each of the first electricity-collecting portions 132 may be a continuous line segment, and each of the second electricity-collecting portions 134 may include a plurality of sub-electricity-collecting portions 134c separated from each other. To be specific, the sub-electricity-collecting portions 134c of the second electricity-collecting portions 134 may be arranged in an array, and each of the first electricity-collecting portions 132 is connected to some of the sub-electricity-collecting portions 132c located in the same column However, the types of the first and second electricity-collecting portions 132 and 134 are not limited to those specified above; in other embodiments of the invention, the first and second electricity-collecting portions 132 and 134 may be of other types.

Note that the first electricity-collecting portions 132 and the second electricity-collecting portions 134 belong to the same film layer. Namely, the first electrode 130 (including the first electricity-collecting portions 132 and the second electricity-collecting portions 134) is integrally formed. For instance, in the present embodiment, the first electricity-collecting portions 132 and the second electricity-collecting portions 134 may be simultaneously formed by screen printing. However, the invention is not limited thereto, and the first electricity-collecting portions 132 and the second electricity-collecting portions 134 provided in other embodiments of the invention may be formed by performing other appropriate steps, e.g., evaporation. Since the first electricity-collecting portions 132 and the second electricity-collecting portions 134 are simultaneously formed, the second electricity-collecting portions 134 may be designed to have non-continuous patterns (e.g., each second electricity-collecting portion 134 may include the sub-electricity-collecting portions 134c separated from each other), and thus no alignment issue may occur between the first and second electricity-collecting portions 132 and 134. That is, owing to the second electricity-collecting portions 134 with the non-continuous pattern design, the light-receiving area of each photovoltaic cells 100 described herein may be expanded, and the photoelectric conversion efficiency of each photovoltaic cells 100 may be enhanced; what is more, the photovoltaic cells 100 can be formed by performing a simple manufacturing process.

With reference to FIG. 2A and FIG. 3, the first electrode 130 described in the present embodiment may selectively include a third electricity-collecting portion 136. The third electricity-collecting portion 136 is located outside the first electricity-collecting portions 132 and the second electricity-collecting portions 134. The first electricity-collecting portions 132, the second electricity-collecting portions 134, and the third electricity-collecting portion 136 described herein are located in the same film layer, which should however not be construed as a limitation to the invention. As shown in FIG. 2A, a first reference line R1 passes through each of the first electricity-collecting portions 132, and each of the first electricity-collecting portions 132 has two different ends 132a and 132b respectively located on two sides of the first reference line R1. Here, the first reference line R1 is a virtual line segment and is not portion of the actual photovoltaic cells 100. The third electricity-collecting portion 136 is at least connected to the same end 132b of each of the first electricity-collecting portions 132. Note that the third electricity-collecting portion 136 allows the first electrode 130 and the bus element 200 that includes the branches 210 (as shown in FIG. 2B) to be easily connected together in no need of precise alignment, and thereby the manufacturing yield of the photovoltaic cell module may be improved. However, the invention is not limited thereto, and the first electrode 130 and the bus element 200 can be connected with ease in a different manner according to another embodiment, which will be exemplified below.

During the process of connecting the first electrode 130 and the bus element 200, the first electrode 130 and the bus element 200 described herein need not be arranged along any specific direction if the third electricity-collecting portion 136 surrounds the first electricity-collecting portions 132 and the second electricity-collecting portions 134. The third electricity-collecting portion 136 may be further connected to the two different ends 132a and 132b of the first electricity-collecting portions 132. Namely, the third electricity-collecting portion 136 may be shaped as a closed ring which surrounds the first electricity-collecting portions 132 and the second electricity-collecting portions 134. Thereby, even if the photovoltaic cells 100 are deviated by a certain angle (e.g., 90 degrees), the photovoltaic cells 100 can be well connected to the bus element 200 through the third electricity-collecting portion 136. In addition, note that the shape of the third electricity-collecting portion 136 is not limited to the closed ring; in order to reduce costs of materials, the third electricity-collecting portion 136 may be shaped as the letter L or in any other appropriate manner.

With reference to FIG. 2B, at least one bus element 200 is provided. According to the present embodiment, the bus element 200 may be integrally formed, which should not be construed as a limitation to the invention; in another embodiment, the branches 210 and the first main portion 220 of the bus element 200 may be individually shaped and then connected together. The bus element 200 described in the present embodiment includes a plurality of branches 210. The bus element 200 may selectively include the first main portion 220 connected to the branches 210. Specifically, the branches 210 may be divided into a plurality of first branches 212 and a plurality of second branches 214. The first branches 212 and the second branches 214 are respectively connected to two opposite sides 220a of the first main portion 220. The first branches 212 are configured to connect the first electrode 130 of one of the photovoltaic cells 100, while the second branches 214 are configured to connect another of the photovoltaic cells 100.

According to the present embodiment, a width W1 of each of the first branches 212 in a direction parallel to the extension direction of the first main portion 220 may be smaller than a width W2 of each of the second branches 214 in the direction. Since the first branches 212 are connected to the first electrodes 130 and cover an area of the photovoltaic cells 100, the area of the photovoltaic cells 100 covered by the first branches 212 is reduced if the first branches 212 have the small width, and thereby the impact of the bus element 200 on the photoelectric conversion efficiency of the photovoltaic cells 100 can be lessened. Besides, in FIG. 2B, there are seven first branches 212 and five second branches 214 in the bus element 200, the first branches 212 are arranged in an equidistant manner, and so are the second branches 214. Nevertheless, the number and the arrangement of the first and second branches 212 and 214 are not limited in the invention and may be properly adjusted according to actual requirements.

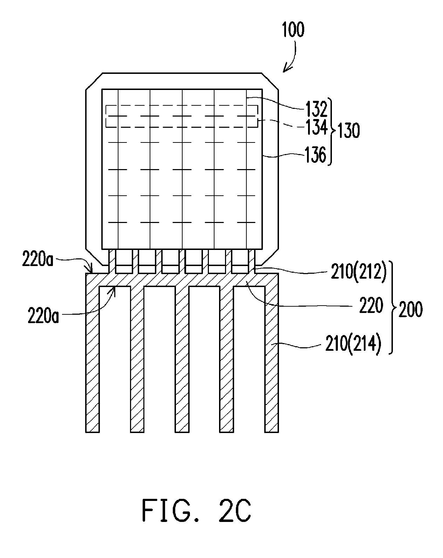

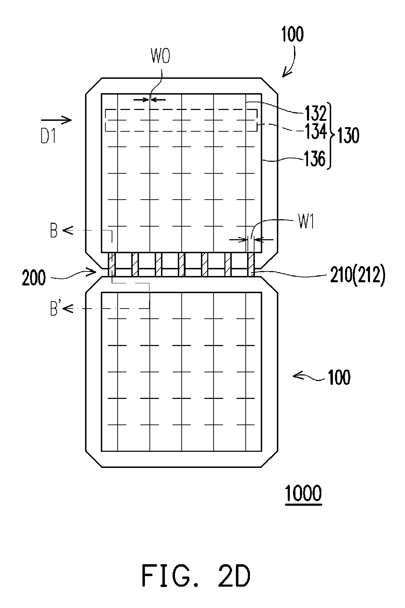

With reference to FIG. 2C and FIG. 2D, the photovoltaic cells 100 and the bus element 200 are arranged in an appropriate manner. For instance, in the present embodiment as shown in FIG. 2C, the third electricity-collecting portion 136 of one photovoltaic cell 100 is in contact with but is not fixed to the branches 210 (e.g., the first branches 212) of the bus element 200. In FIG. 2D, another photovoltaic cell 100 is in contact with but is not fixed to the bus element 200. According to the present embodiment, the first main portion 220 and the branches 210 (e.g., the first branches 212) of the bus element 200 may be in contact with the second electrode 140 of another photovoltaic cells 100.

FIG. 4 is a cross-sectional view taken along a section line B-B' shown in FIG. 2D. With reference to FIG. 2D and FIG. 4, the photovoltaic cells 100 are simultaneously fixed to and electrically connected to the bus element 200. In the present embodiment, the bus element 200 may be simultaneously fixed to and electrically connected to the first electrode 130 of one of the photovoltaic cells 100 and the second electrode 140 of another of the photovoltaic cells 100. The method of simultaneously fixing the photovoltaic cells 100 to the bus element 200 and electrically connecting the photovoltaic cells 100 to the bus element 200 includes: heating the photovoltaic cells 100 and the bus element 200 at the same time. In detail, the bus element 200 may have a solder layer located on the surface of the bus element 200, and the solder layer of the bus element 200 is melted and distributed onto the photovoltaic cells 100 while the photovoltaic cells 100 and the bus element 200 are simultaneously heated. After the temperature of the photovoltaic cells 100 and the bus element 200 drops to the normal temperature, the photovoltaic cells 100 can be simultaneously fixed to and electrically connected to the bus element 200.

In particular, according to the present embodiment, the photovoltaic cells 100 and the bus element 200 can be arranged on a heating board in an appropriate manner, and the photovoltaic cells 100 and the bus element 200 are simultaneously heated by means of the heating board, so as to fix the bus element 200 to the photovoltaic cells 100 simultaneously. The photovoltaic cells 100 and the bus element 200 may be sandwiched by two heating boards and are then simultaneously heated. During the heating process, one of the two heating boards may be in contact with the first electrode 130 of one of the photovoltaic cells 100 and the first branches 210 of the bus element 200, and the other heating board may be in contact with the second electrode 140 of another of the photovoltaic cells 100 and the second branches 214 of the bus element 200. Thereby, the connection between the bus element 200 and the photovoltaic cells 100 can be improved quality, and the reliability of the photovoltaic cell module 1000 can be enhanced. However, the invention is not limited thereto, and the bus element 200 can be fixed to respective photovoltaic cells 100 at different time points.

After the photovoltaic cells 100 are simultaneously fixed to and electrically connected to the bus element 200, a back plate (not shown), a first transparent protection film (not shown), the photovoltaic cells 100 and the bus element 200 that are fixed to each other, a second transparent protection film (not shown), and a transparent protection substrate (not shown) are stacked in an appropriate order, and a lamination machine is applied to connect the back plate, the first transparent protection film, the photovoltaic cells 100 and the bus element 200 that are fixed to each other, the second transparent protection film, and the transparent protection substrate, so as to form the photovoltaic cell module 1000 described in the present embodiment.

### Photovoltaic Cell Module

With reference to FIG. 2D and FIG. 4, the photovoltaic cell module 1000 provided in the present embodiment serves to convert energy of light into electric energy. The photovoltaic cell module 1000 includes a plurality of photovoltaic cells 100 and at least one bus element 200. A first electrode 130 of one of the photovoltaic cells 100 is electrically connected to another of the photovoltaic cells 100 through the bus element 200.

The bus element 200 described in the present embodiment includes a plurality of branches 210. An extension direction of each of the branches 210 is different from an extension direction of each of the second electricity-collecting portions 134. According to the present embodiment, the extension direction of each of the branches 210 may be substantially perpendicular to the extension direction of each of the second electricity-collecting portions 134; however, the invention is not limited thereto. Note that a width W0 of each of the first electricity-collecting portions 132 in a direction D1 crossing with the extension direction of each of the first electricity-collecting portions 134 may be smaller than a width W1 of each of the branches 210 (the first branches 212) in the direction D1. Specifically, the ratio of the width W0 to the width W may be less than or equal to 0.5. The first electricity-collecting portions 132 with the small width allows the amount of light entering the photovoltaic cells to be increased, and thereby the photoelectric conversion efficiency of the photovoltaic cell module 1000 can be enhanced.

With reference to FIG. 2C, FIG. 2D, and FIG. 4, the bus element 200 described in the present embodiment includes a first main portion 220. The first main portion 220 is connected to the branches 210. An extension direction of the first main portion 220 is different from an extension direction of each of the first electricity-collecting portions 132. According to the present embodiment, the extension direction of the first main portion 220 may be substantially perpendicular to the extension direction of each of the first electricity-collecting portions 132. The branches 210 are divided into a plurality of first branches 212 and a plurality of branches 214. The first branches 212 are connected to the first electrode 130 of one of the photovoltaic cells 100 and the first main portion 220. The second branches 214 are connected to the first main portion 220 and second electrode 140 of another of the photovoltaic cells 100. As shown in FIG. 4, in the present embodiment, the second branches 214 can be connected to the first main portion 220 and the second electrode 140 of another photovoltaic cell 100.

### Second Embodiment

### Photovoltaic Cell Module

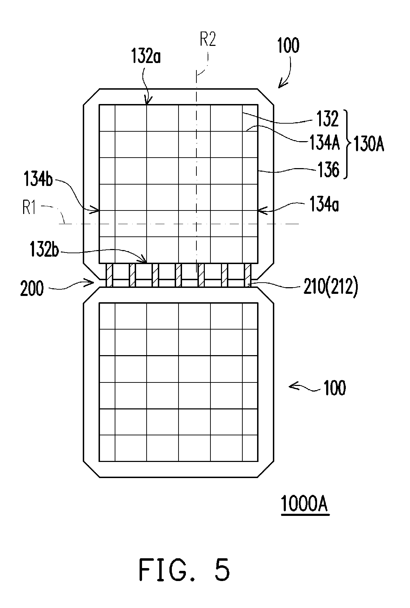

FIG. 5 is a schematic top view illustrating a photovoltaic cell module according to an embodiment of the invention. With reference to FIG. 5, the photovoltaic cell module 1000A described in the present embodiment is similar to the photovoltaic cell module 1000 described in the first embodiment, and therefore the same components are labeled by the same reference numbers. The difference between these two embodiments lies in that the first electrodes 130A in the photovoltaic cells 100 of the photovoltaic cell module 1000A are different from the first electrodes 130 provided in the first embodiment. The difference is described below, while the similarity will not be further explained. Besides, the method of fabricating the photovoltaic cell module 1000A described in the present embodiment is also similar to the method of fabricating the photovoltaic cell module 1000 described in the first embodiment. Hence, relevant descriptions of the method of fabricating the photovoltaic cell module 1000A may be deduced from those provided in the first embodiment.

According to the present embodiment, the photovoltaic cell module 1000A includes a plurality of photovoltaic cells 100 and at least one bus element 200. The first electrode 130A of one of the photovoltaic cells 100 is electrically connected to another of the photovoltaic cells 100 through the bus element 200. In the present embodiment, the first electrode 130A of the photovoltaic cells 100 includes a plurality of first electricity-collecting portions 132 and a plurality of second electricity-collecting portions 134A. The first electricity-collecting portions 132 and the second electricity-collecting portions 134A cross with each other and belong to the same film layer.

Different from the first embodiment, the present embodiment discloses that each of the second electricity-collecting portions 134A may be a continuous line segment. To be specific, a second reference line R2 passes through the second electricity-collecting portions 134A, and each of the second electricity-collecting portions 134A has two different ends 134a and 134b respectively located on two sides of the second reference line R2. Here, the second reference line R2 is a virtual line segment and is not portion of the actual photovoltaic cells 100. The third electricity-collecting portion 136 is further connected to the two different ends 134a and 134b of the second electricity-collecting portions 134A. Particularly, in the present embodiment, the third electricity-collecting portion 136 surrounds the first electricity-collecting portions 132 and the second electricity-collecting portions 134A and is connected to all ends of the first and second electricity-collecting portions 132 and 134A. The effects and advantages of the photovoltaic cell module 1000A described in the present embodiment are similar to the effects and advantages of the photovoltaic cell module 1000 described in the first embodiment and thus will not be further elaborated hereinafter.

### Third Embodiment

### Method of Fabricating Photovoltaic Cell Module

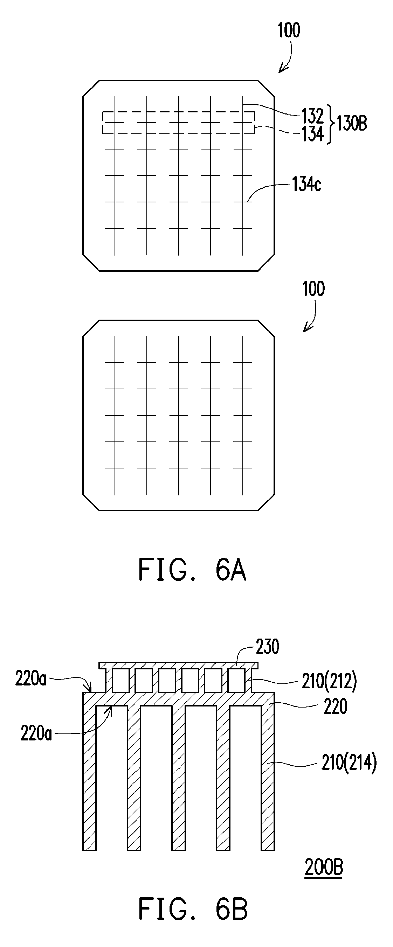

FIG. 6A to FIG. 6D are schematic top views illustrating a method of fabricating a photovoltaic cell module according to an embodiment of the invention. The method of fabricating the photovoltaic cell module described herein is similar to that provided in the first embodiment, and thus the same steps and the same components are represented by the same reference numbers. The difference between these two embodiments lies in that the types of the first electrodes 130B and the bus element 200B of the photovoltaic cells 100 provided herein are different from those described in the first embodiment, which slightly differentiates the fabricating method provided herein from the fabricating method described in the first embodiment. The difference is described below, while the similarity will not be further explained.

With reference to FIG. 6A, a plurality of photovoltaic cells 100 are provided. The difference between the photovoltaic cells 100 provided in the present embodiment and those described in the first embodiment lies in that the first electrode 130B in each photovoltaic cells 100 may not include the third electrode 136 according to the present embodiment; as a matter of fact, the third electrode 136 capable of performing certain functions may be replaced by the first main portion 230 of the bus element 200B, as shown in FIG. 6B.

With reference to FIG. 6B, at least one bus element 200B is provided. The bus element 200B described in the present embodiment includes a plurality of branches 210. The bus element 200B further includes a first main portion 230. The first main portion 230 is connected to the branches 210. The branches 210 are located on one side (on the same side) of the first main portion 230. The bus element 200B further includes a second main portion 220. The branches 210 are divided into a plurality of first branches 212 and a plurality of second branches 214. The first main portion 230 is connected to the second main portion 220 through the first branches 212. The first branches 212 are connected to the second branches 214 through the second main portion 220.

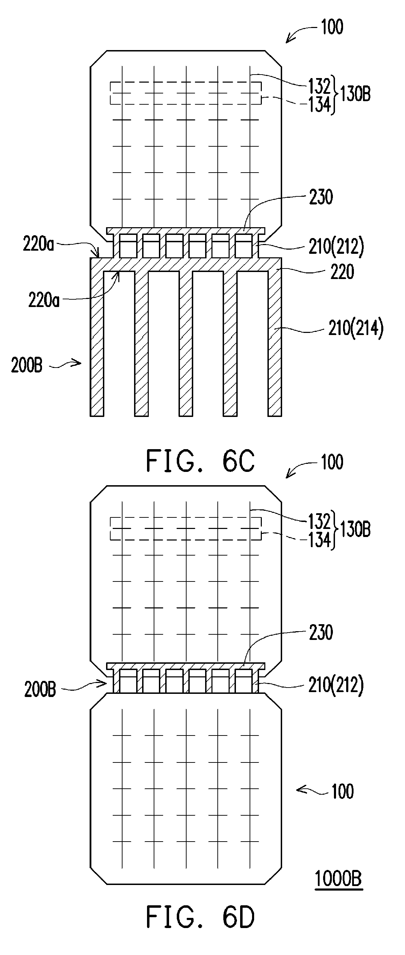

With reference to FIG. 6C and FIG. 6D, the photovoltaic cells 100 and the bus element 200B are arranged in an appropriate manner. For instance, in the present embodiment as shown in FIG. 6C, the first electricity-collecting portions 132 of one photovoltaic cells 100 are in contact with but are not fixed to the first main portion 230 of the bus element 200B. In FIG. 6D, another photovoltaic cells 100 may be in contact with at least some of the branches 210 (e.g., the second branches 214) of the bus element 200B. As shown in FIG. 6D, the photovoltaic cells 100 are then simultaneously fixed to and electrically connected to the one bus element 200B, so as to form the photovoltaic cell module 1000B described in the present embodiment.

### Photovoltaic Cell Module

FIG. 6D is a schematic top view illustrating a photovoltaic cell module according to an embodiment of the invention. With reference to FIG. 6D, the photovoltaic cell module 1000B described in the present embodiment is similar to the photovoltaic cell module 1000 described in the first embodiment, and therefore the same components are labeled by the same reference numbers. The difference between these two embodiments lies in that the bus element 200B and the first electrodes 130B in the photovoltaic cells 100 of the photovoltaic cell module 1000B are different from the bus element 200 and the first electrodes 130 provided in the first embodiment. The difference is described below, while the similarity will not be further explained.

According to the present embodiment, the photovoltaic cell module 1000B includes a plurality of photovoltaic cells 100 and at least one bus element 200B. The first electrode 130B of one of the photovoltaic cells 100 is electrically connected to another of the photovoltaic cells 100 through the bus element 200B. The difference between the first electrodes 130B of the photovoltaic cells 100 provided in the present embodiment and the first electrodes 130 described in the first embodiment lies in that the first electrode 130B in each photovoltaic cell 100 may not include the third electricity-collecting portion 136 according to the present embodiment.

With reference to FIG. 6C and FIG. 6D, the bus element 200B described in the present embodiment includes a plurality of branches 210. An extension direction of each of the branches 210 is different from an extension direction of each of the second electricity-collecting portions 134. The bus element 200B further includes a first main portion 230. The first main portion 230 is connected to the branches 210. An extension direction of the first main portion 230 is different from an extension direction of each of the first electricity-collecting portions 132. The branches 210 are located on one side (on the same side) of the first main portion 230, and the first main portion 230 is connected to the first electricity-collecting portions 230 and the branches 210.

In the present embodiment, the bus element 200B further includes a second main portion 220. The branches 210 are divided into a plurality of first branches 212 and a plurality of second branches 214. The first main portion 230 is connected to the first electricity-collecting portions 132 of one of the photovoltaic cells 100 and the first branches 212. The second main portion 220 is connected to the first branches 212 and the second branches 214. The second branches 214 are connected to the second main portion 220 and another of the photovoltaic cells 100. Note that the first main portion 230 of the bus element 200B described herein may be applied to replace the third electricity-collecting portion 136 described in the first embodiment. The effects and advantages of the photovoltaic cell module 1000B described in the present embodiment are similar to the effects and advantages of the photovoltaic cell module 1000 described in the first embodiment and thus will not be further elaborated hereinafter.

### Fourth Embodiment

### Photovoltaic Cell Module

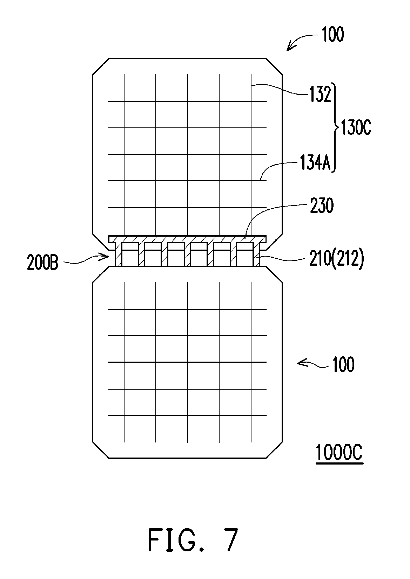

FIG. 7 is a schematic top view illustrating a photovoltaic cell module according to an embodiment of the invention. With reference to FIG. 7, the photovoltaic cell module 1000C described in the present embodiment is similar to the photovoltaic cell module 1000B described in the third embodiment, and therefore the same components are labeled by the same reference numbers. The difference between these two embodiments lies in that the first electrodes 130C in the photovoltaic cells 100 of the photovoltaic cell module 1000C are different from the first electrodes 130B provided in the third embodiment. The difference is described below, while the similarity will not be further explained. The method of fabricating the photovoltaic cell module 1000C provided in the present embodiment is also similar to the method of fabricating the photovoltaic cell module 1000B provided in the third embodiment, and thus relevant descriptions of the method of fabricating the photovoltaic cell module 1000C may be deduced from those provided in the third embodiment.

According to the present embodiment, the photovoltaic cell module 1000C includes a plurality of photovoltaic cells 100 and at least one bus element 200B. The first electrode 130C of one of the photovoltaic cells 100 is electrically connected to another of the photovoltaic cells 100 through the bus element 200B. In the present embodiment, the first electrode 130C of the photovoltaic cell 100 includes a plurality of first electricity-collecting portions 132 and a plurality of second electricity-collecting portions 134A. The first electricity-collecting portions 132 and the second electricity-collecting portions 134A cross with each other and belong to the same film layer. Different from the first embodiment, the present embodiment discloses that each of the second electricity-collecting portions 134A may be a continuous line segment. The effects and advantages of the photovoltaic cell module 1000C described in the present embodiment are similar to the effects and advantages of the photovoltaic cell module 1000B described in the third embodiment and thus will not be further elaborated hereinafter.

To sum up, in the photovoltaic cell module described herein and the method of manufacturing the same, through the special pattern design of the first electrodes of the photovoltaic cells, adjacent photovoltaic cells are allowed to be simultaneously fixed to and electrically connected to the bus element. Thereby, the manufacturing process of the photovoltaic cell module can be simplified, and the manufacturing costs may be lowered down. Moreover, the light-receiving area of the photovoltaic cell can be expanded because of the electrode having the special pattern design, and thus the photoelectric conversion efficiency of the photovoltaic cell module can be enhanced.

Although the invention has been described with reference to the above embodiments, it will be apparent to one of the ordinary skill in the art that modifications to the described embodiment may be made without departing from the spirit of the invention. Accordingly, the scope of the invention will be defined by the attached claims not by the above detailed descriptions.

## Claims

1. A photovoltaic cell module 1000 configured to convert energy of light L into electric energy, the photovoltaic cell module 1000 comprising:
a plurality of photovoltaic cells 100, each of the photovoltaic cells 100 comprising:
a first-type semiconductor layer 110;
a second-type semiconductor layer 120 having an interface S in contact with the first-type semiconductor layer 110; and
a first electrode 130, the first-type semiconductor layer 110 being located between the first electrode 130 and the second-type semiconductor layer 120, the light L entering each of the photovoltaic cells 100 along a direction from the first electrode 130 to the interface S, the first electrode 130 comprising:
a plurality of first electricity-collecting portions 132; and
a plurality of second electricity-collecting portions 134, the first electricity-collecting portions 132 and the second electricity-collecting portions 134 crossing with each other and belonging to a single film layer.

2. The photovoltaic cell module 1000 as recited in claim 1, wherein each of the first electricity-collecting portions 132 is a continuous line segment, and each of the second electricity-collecting portions 134 comprises a plurality of sub-electricity-collecting portions 134c separated from each other, the sub-electricity-collecting portions 134c of the second electricity-collecting portions 134 are arranged in an array, and each of the first electricity-collecting portions 132 is connected to some of the sub-electricity-collecting portions 134c located in a single column where the each of the first electricity-collecting portions 132 is located.

3. The photovoltaic cell module 1000 as recited in claim 1, wherein each of the first electricity-collecting portions 132 and each of the second electricity-collecting portions 134A are continuous line segments.

4. The photovoltaic cell module 1000A as recited in claim 1, wherein the first electrode 130A further comprises:
a third electricity-collecting portion 136 located outside the first electricity-collecting portions 132 and the second electricity-collecting portions 134, a first reference line R1 passes through the first electricity-collecting portions 132, each of the first electricity-collecting portions 132 has two different ends 132a, 132b respectively located on two sides of the first reference line R1, and the third electricity-collecting portion 136 is connected to the ends located on the single side of the first reference line R1 of the first electricity-collecting portions 132, the third electricity-collecting portion 136 surrounds the first electricity-collecting portions 132 and the second electricity-collecting portions 134, the third electricity-collecting portion 136 is connected to the two different ends 132a, 132b of the first electricity-collecting portions 132, a second reference line R2 passes through the second electricity-collecting portions 134, each of the second electricity-collecting portions 134 has two different ends 134a, 134b respectively located on two sides of the second reference line R2, and the third electricity-collecting portion 136 is connected to the two different ends 134a, 134b of the second electricity-collecting portions 134.

5. The photovoltaic cell module 1000 as recited in claim 1, further comprising:
at least one bus element 200, the first electrode 130 of one of the photovoltaic cells 100 being electrically connected to another of the photovoltaic cells 100 through the at least one bus element 200, the at least one bus element 200 comprises a plurality of branches 210 , and an extension direction of each of the branches 210 is different from an extension direction of each of the second electricity-collecting portions 134.

6. The photovoltaic cell module 1000 as recited in claim 5, wherein a width W0 of each of the first electricity-collecting portions 132 in a direction crossing with an extension direction of each of the first electricity-collecting portions 132 is smaller than a width W1 of each of the branches in the direction.

7. The photovoltaic cell module 1000 as recited in claim 5, wherein the at least one bus element 200 further comprises a first main portion 220 connected to the branches 210, and an extension direction of the first main portion 220 is different from an extension direction of each of the first electricity-collecting portions 132.

8. The photovoltaic cell module 1000 as recited in claim 7, wherein the branches are divided into a plurality of first branches 212 and a plurality of second branches 214, the first branches 212 are connected to the first main portion 220 and the first electrode 130 of one of the photovoltaic cells 100, and the second branches 214 are connected to the first main portion 220 and another of the photovoltaic cells 100, the branches 210 are located on a single side of the first main portion 220, and the first main portion 220 is connected to the first electricity-collecting portions 132 and the branches 210.

9. The photovoltaic cell module 1000B as recited in claim 8, wherein the at least one bus element 200B further comprises a second main portion 230, the branches 210 are divided into a plurality of first branches 212 and a plurality of second branches 214, the first main portion 220 is connected to the first electricity-collecting portions 132 of one of the photovoltaic cells 100 and the first branches 212, the second main portion 230 is connected to the first branches 212 and the second branches 214, and the second branches 214 are connected to the second main portion 230 and another of the photovoltaic cells 100.

10. The photovoltaic cell module 1000 as recited in claim 5, wherein the at least one bus element 200 is integrally formed.

11. A method of fabricating a photovoltaic cell module 1000, comprising:
providing a plurality of photovoltaic cells 100, each of the photovoltaic cells 100 being configured to convert energy of light L into electric energy and comprising a first-type semiconductor layer 110, a second-type semiconductor layer 120, and a first electrode 130, the first-type semiconductor layer 110 being located between the first electrode 130 and the second-type semiconductor layer 120, an interface S being located between the first-type semiconductor layer 110 and the second-type semiconductor layer 120, the light entering each of the photovoltaic cells 100 along a direction from the first electrode 130 to the interface S, wherein the first electrode 130 comprises a plurality of first electricity-collecting portions 132 and a plurality of second electricity-collecting portions 134, and the first electricity-collecting portions 132 and the second electricity-collecting portions 134 cross with each other and belong to a single film layer;
providing at least one bus element 200; and
simultaneously fixing the photovoltaic cells 100 to the at least one bus element 200 and electrically connecting the photovoltaic cells 100 to the at least one bus element 200.

12. The method of fabricating the photovoltaic cell module 1000 as recited in claim 11, wherein the step of simultaneously fixing the photovoltaic cells 100 to the at least one bus element 200 and electrically connecting the photovoltaic cells 100 to the at least one bus element 200 comprises:
simultaneously heating the photovoltaic cells 100 and the at least one bus element 200.

13. The method of fabricating the photovoltaic cell module 1000 as recited in claim 11, wherein the first electrode 130 further comprises: a third electricity-collecting portion 136 located outside the first electricity-collecting portions 132 and the second electricity-collecting portions 134, a first reference line R1 passes through the first electricity-collecting portions 132, each of the first electricity-collecting portions 132 has two different ends 132a, 132b respectively located on two sides of the first reference line R1, and the third electricity-collecting portion 136 is connected to the ends located on the single side of the first reference line R1 of the first electricity-collecting portions 132.

14. The method of fabricating the photovoltaic cell module 1000 as recited in claim 13, wherein the at least one bus element 200 comprises a plurality of branches 210, and the method of fabricating the photovoltaic cell module 1000 further comprises:
making the third electricity-collecting portion 136 of one of the photovoltaic cells 100 to be in contact with the branches 210 of the at least one bus element 200 before simultaneously fixing the photovoltaic cells 100 to the at least one bus element 200; and
making another of the photovoltaic cells 100 to be in contact with the at least one bus element 200 before simultaneously fixing the photovoltaic cells 100 to the at least one bus element 200, or wherein the at least one bus element 200 further comprises a plurality of branches 210 and a first main portion 220 connected to the branches 214, the branches 210 are divided into a plurality of first branches 212 and a plurality of second branches 214, the first branches 212 and the second branches 214 are respectively located on two opposite sides of the first main portion 220, and the method of fabricating the photovoltaic cell module 1000 further comprises:
making the third electricity-collecting portion 136 of one of the photovoltaic cells 100 to be in contact with the first branches 212 of the at least one bus element 200 before simultaneously fixing the photovoltaic cells 100 to the at least one bus element 200; and
making another of the photovoltaic cells 100 to be in contact with the second branches 214 of the at least one bus element 200 before simultaneously fixing the photovoltaic cells 100 to the at least one bus element.

15. The method of fabricating the photovoltaic cell module 1000 as recited in claim 11, wherein the at least one bus element 200 comprises a first main portion 220 and a plurality of branches 210, the first main portion 220 is connected to the branches 210, the branches 210 are located on a single side of the first main portion 220, and the method of fabricating the photovoltaic cell module 1000 further comprises:
making the first electricity-collecting portions 132 of one of the photovoltaic cells 100 to be in contact with the first main portion 210 of the at least one bus element 200 before simultaneously fixing the photovoltaic cells 100 to the at least one bus element 200; and
making another of the photovoltaic cells 100 to be in contact with at least some of the branches 210 of the at least one bus element 200 before simultaneously fixing the photovoltaic cells 100 to the at least one bus element 200.
